# EUROPEAN PATENT SPECIFICATION

(11) **EP 3 239 819 B1**
(45) Date of publication and mention of the grant of the patent: **06.03.2019**
(21) Application number: 15877869.6
(22) Date of filing: 29.01.2015
(51) Int. Cl.: G06F 3/041, G06F 3/042

(54) **DEVICE AND METHOD FOR CONTACTLESS INPUT**
VORRICHTUNG UND VERFAHREN FÜR KONTAKTLOSE EINGABE
DISPOSITIF ET PROCÉDÉ D'ENTRÉE SANS CONTACT

(30) Priority: 15.01.2015 JP 2015005928
(43) Date of publication of application: 01.11.2017
(73) Proprietor: Asukanet Company, Ltd., Hiroshima-shi, Hiroshima 731-0138 (JP)
(72) Inventor: OTSUBO Makoto, Hiroshima-shi Hiroshima 731-0138 (JP)
(74) Representative: Vossius & Partner Patentanwälte Rechtsanwälte mbB
(86) International application number: PCT/JP2015/052508
(87) International publication number: WO 2016/113917

(56) References cited:
- EP-A1- 2 498 123
- JP-A- 2008 204 047
- JP-A- 2014 240 983
- JP-B1- 5 509 391
- US-A1- 2008 074 401
- US-A1- 2011 109 592
- US-A1- 2014 240 228

## Description

### TECHNICAL FIELD

The present invention relates to an apparatus and method for contactless input (i.e., an apparatus and method for contactlessly detecting an indicated position on a reproduced image) with and by which a real image becomes formed in the air, and a signal can be input by operation of an indicating means (e.g., a finger) while looking at this real image (e.g., an image of a touch panel).

### BACKGROUND ART

It has been known that when an image becomes displayed on a display and a particular position on the image is pressed by a finger, X and Y coordinates of the pressed part become detected by a pressure-sensitive sensor and the like, and by means of this input signal, a subsequent behavior is performed (see e.g., Patent Literature 1).

Also, as described in Patent Literature 2, in the case of forming a matrix by numerously and parallelly arranging light emitting elements and light receiving elements along X- and Y-axis immediately above a display and touching a surface of the display with an obstacle such as a finger, a pen and the like, it is proposed to detect a position having come into direct contact with the display by traversing of the obstacle on the matrix.

On the other hand, in Patent Literature 3, there are proposed a method and apparatus for detecting an indicated position on a reproduced image of a display by using an optical image formation means in which a first light control panel formed by arranging a number of first planar light-reflective portions parallel to one another at constant intervals inside a transparent flat plate and a second light control panel formed by arranging a number of second planar light-reflective portions parallel to one another at constant intervals inside a transparent flat plate are arranged in direct contact with or proximity to each other in a manner that makes the first planar light-reflective portions and the second planar light-reflective portions orthogonal in planar view, by simultaneously displaying an image on a display and an image formed through making infrared light irregularly reflect off the surface of the display as reproduced images in the air, and detecting a position of an indicating means having touched the reproduced image of the display by a two-dimensional infrared camera.

Also, as described in Patent Literature 4, there is a proposal of an apparatus that cognizes shapes of movements of a multi-touch by means of fingers or a stylus pen (touch pen) on a liquid-crystal surface by incorporating a light sensor into a transistor-shaped surface composing a liquid-crystal panel. Document US2014240228A1 discloses a touch less computer/human interaction device wherein a real image of a graphical user interface rendered by an underlying display panel is projected into a 3D space by means of a micro mirror grid. The interaction of a user is with the real image of the graphical user interface image is captured by additional image capturing means.

### CITED DOCUMENT

### PATENT LITERATURE

Patent Literature 1: Japanese Unexamined Patent Application Publication No. 2006-039745
Patent Literature 2: Japanese Unexamined Patent Application Publication No. 2000-056928
Patent Literature 3: Japanese Patent No. 5509391
Patent Literature 4: Japanese Unexamined Patent Application Publication No. 2011-029919

### SUMMARY OF INVENTION

### TECHNICAL PROBLEM

However, the touch panels described in Patent Literatures 1 and 2 each had a structure in which a planar display existed on the back side, a particular planar image became displayed on the display, and an input position was detected by pressing a particular position on the display. Therefore, when the image was pressed by a finger, a pen and the like, the finger, the pen and the like inevitably came into contact or collided with the display surface, which sometimes resulted in dirtiness of or scratches on the display.

In Patent Literature 3, there is a problem in that a light source for infrared light, an irregular reflection surface for infrared light, and an infrared camera are required aside from the display panel, which adds additional complexity to a structure of the apparatus.
In Patent Literature 4, there are proposed an optical touch panel provided with a liquid-crystal panel having a backlight and a light sensor detecting touches on the liquid-crystal panel by reflected light. However, the touch panel does not have an imaging system in which an image is formed in the air.

Touch panels for which displays are used have been used for ATMs and the like. However, it is not hygienic since a large, indefinite number of people touch screens, and it has not been effective for the prevention of contact infections.
Also, when the displays are irradiated with light, the light becomes reflected off and emitted from the displays, which has sometimes made it hard to look at the displays.

The present invention has been made in view of the above circumstances, and an object thereof is to provide an apparatus and method for contactless input which enable signal input without physically touching a display by making an image to be formed a spatial image that is not reflected light from other light sources, and detecting a position indicated on the spatial image when a particular position on the spatial image is indicated by an indicating means such as a finger, a pointer, a touch pen and the like.

### SOLUTION TO PROBLEM

In order to achieve the above object, according to a first aspect of the present invention, there is provided an apparatus for contactless input including a display having a number of light-emitting blocks, part or all of the light-emitting blocks each having one of light sensors incorporated; and an optical image formation means having a number of first minute reflective surfaces and a number of second minute reflective surfaces arranged crossed in planar view, the first minute reflective surfaces arranged standing on a same plane, the second minute reflective surfaces arranged standing on a same plane, first reflected light from each of the first minute reflective surfaces being reflected on the corresponding second minute reflective surfaces to form second reflected light, wherein a first real image is formed from an image on the display by means of the optical image formation means, the display being arranged on one side of the optical image formation means, the first real image being formed on the other side of the optical image formation means; a second real image is formed on the display on one side of the optical image formation means, from an image of an indicating means having come into contact with the first real image; and a position of the second real image is detected by the light sensors of the display.

Among images to be displayed on the display are an image of a touch panel, an image of a keyboard and the like, however, the images can be both usual color pictures (images) or monochrome pictures (images) (hereinafter the same applies to a method for contactless input).

In the case of the apparatus for contactless input according to the first aspect of the present invention, it is preferred that the light sensors be infrared sensors, and that each of the light-emitting blocks have one of infrared-light emitting portions and one of the infrared sensors aside from one of visible-light emitting portions. Also, it is preferred that a filter and the like be used for each of the infrared sensors in order not to detect visible light. However, it is not a mandatory requisite, and the light sensors can also be visible light sensors.

In the case of the apparatus for contactless input according to the first aspect of the present invention, the light sensors can be infrared sensors, each of the light-emitting blocks can have one of the infrared sensors besides one of the visible-light emitting portions, the apparatus for contactless input can also be provided with an infrared-light emitting means irradiating the indicating means having come into contact with the first real image from the side of the optical image formation means, separately from the display, and the position of the second real image can be detected by the infrared sensors.

In the case of the apparatus for contactless input according to the first aspect of the present invention, it is preferred that each of the visible-light emitting portions have an R light-emitting means, a G light-emitting means and a B light-emitting means. Here, R refers to red, G refers to green and B refers to blue.

In the case of the apparatus for contactless input according to the first aspect of the present invention, it is preferred that the display be a liquid-crystal type. Therefore, the display has a light source (backlight) on the back side of a liquid-crystal surface. When one of the infrared-light emitting portions is provided to each of the light-emitting blocks, it is preferred that the light source include an infrared-light emitting source.

In the case of the apparatus for contactless input according to the first aspect of the present invention, the display can be a light-emitting diode type. In this case, light-emitting diodes of three primary colors can be used for the visible-light emitting portions, and infrared-light emitting diodes can be used for the infrared-light emitting portions.

In the case of the apparatus for contactless input according to the first aspect of the present invention, as the optical image formation means, one described in Japanese Patent No. 5036898 can be used, and one described in Japanese Patent No. 4734652 in which unitary optical elements each having two mutually orthogonal light reflective surfaces are arranged planarly and side by side can be used as well.

According to a second aspect of the present invention, there is provided a method for contactless input using a display having a number of light-emitting blocks, part or all of the light-emitting blocks each having one of light sensors incorporated, and an optical image formation means having first minute reflective surfaces and second minute reflective surfaces arranged crossed in planar view, the first minute reflective surfaces arranged in a state of standing numerously on a same plane, the second minute reflective surfaces arranged in a state of standing numerously on a same plane, first reflected light from each of the first minute reflective surfaces being reflected on each of the corresponding second minute reflective surfaces to form second reflected light, the method for contactless input, comprising steps of: forming a first real image from an image on the display arranged on one side of the optical image formation means by means of the optical image formation means, the first real image being formed on the other side of the optical image formation means; forming a second real image from an image of an indicating means having come into contact with the first real image, the second real image being formed on the display on one side of the optical image formation means; and detecting a position of the second real image formed on the display on one side of the optical image formation means by means of the light sensors of the display.

In the case of the method for contactless input according to the second aspect of the present invention, it is preferred that the light sensors be infrared sensors, and it is preferred that each of the light-emitting blocks be provided with one of the infrared sensors aside from one of visible-light emitting portions each having an R light-emitting means, a G light-emitting means and a B light-emitting means.
In the case of this method for contactless input, each of the light-emitting blocks can be provided with one of infrared-light emitting portions, or an infrared-light emitting means irradiating infrared light toward the indicating means can be provided separately, or both can be provided at the same time.

It is preferred that light (including infrared light) emitted from the display or infrared light from the infrared-light emitting means be high-frequency-modulated and separated from natural light.

### Advantageous Effects of Invention

In the apparatus and method for contactless input according to the present invention, a first real image is formed in space from an image on the display by means of the optical image formation means, a second real image is formed on one side of the optical image formation means, for example, on the display, from an image of an indicating means having touched this first real image, by means of the optical image formation means, and a position of this second real image is detected by the light sensors. Accordingly a position of an indicating means can be detected relatively easily. Additionally, unlike the conventional ways, a special two-dimensional infrared camera or the like is unnecessary.
Even when a position of the display changes with respect to the optical image formation means, an image of an indicating means becomes formed on the original display.

In the case of the apparatus and method for contactless input according to the present invention, when the display has infrared-light emitting portions and infrared sensors, regardless of changes in visible light, the position of an indicating means can be detected by only infrared light. When infrared light is emitted from a separately-placed infrared-light emitting means, a structure of the display can be simplified.

When visible light is used as light, a conventional "light sensor liquid-crystal pad" can be used as the display without any change. In this case, when an image on the display is a keyboard and the like, it is preferred that a special radial image (e.g., a spotlight) be provided to each individual keyboard image. Positions of the light sensors can thereby be aligned with each radial image, enabling the enhancement of detection accuracy.

### BRIEF DESCRIPTION OF DRAWINGS

FIG. 1 is an explanatory diagram of an apparatus for contactless input according to a first embodiment of the present invention.
FIG. 2 is an explanatory diagram of an optical image formation means for use in the same apparatus for contactless input.
FIGs. 3(A) and 3(B) each are an explanatory diagram of a display for use in the same apparatus for contactless input.
FIG. 4 is an explanatory diagram of a display according to a variation for use in the same apparatus for contactless input.
FIGs. 5(A) and 5(B) each are an explanatory diagram of a display for use in an apparatus for contactless input according to a second embodiment of the present invention.
FIG. 6 is an explanatory diagram of an apparatus for contactless input according to a third embodiment of the present invention.
FIG. 7 is an explanatory diagram of a display for use in the same apparatus for contactless input.

### DESCRIPTION OF EMBODIMENTS

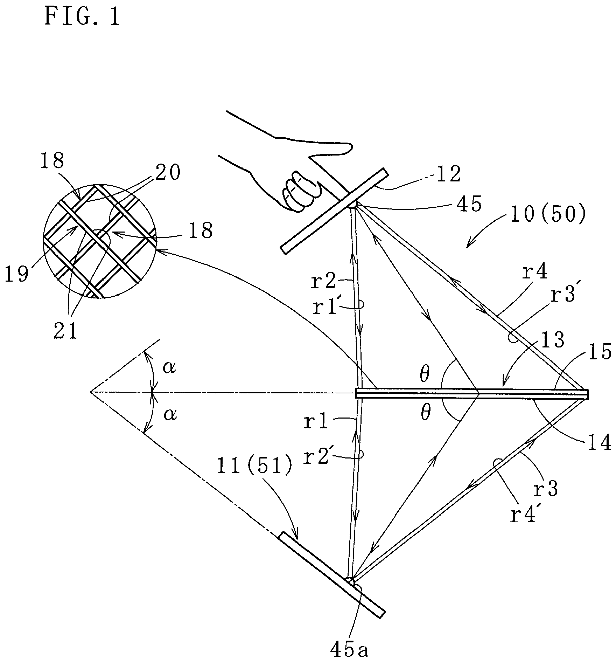

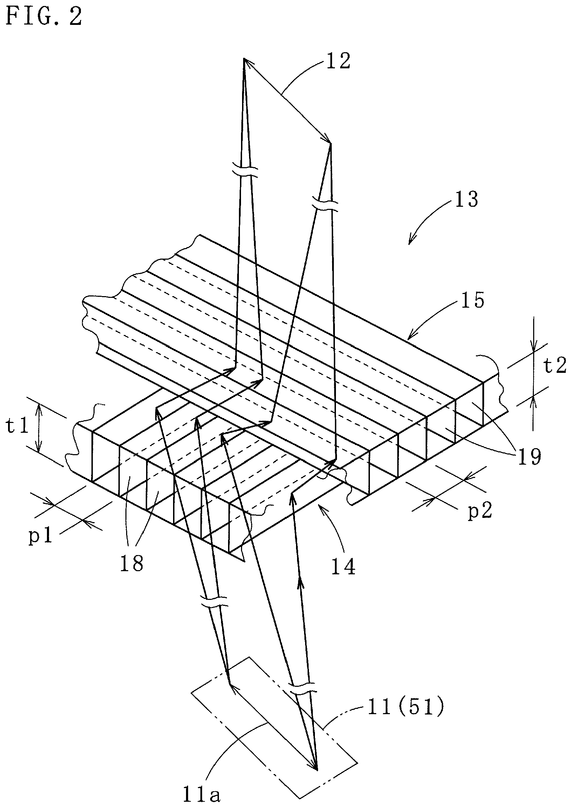

Next, with reference to the accompanying drawings, descriptions will be given on embodiments of the present invention.
As illustrated in FIGs. 1 and 2, an apparatus for contactless input 10 according to a first embodiment of the present invention is provided with an optical image formation means 13 that is formed at an angle α of 30 to 60 degrees to and at a distance from a planar display 11 and that forms a real image 12 of an image on the display 11 at a symmetrical position to the image on the display 11 by receiving the light of the image on the display 11. Here, as a display, aside from a tabular one like an ordinary liquid-crystal display, a tridimensional one having a light source on the inside or one having concavities and convexities formed only on one side like a keyboard can also be used (the same applies to other embodiments as well). Also, when a transparent material such as transparent plastic, glass and the like is used as a main material of the optical image formation means 13, upon entrance of light from the air into the transparent material and exit of the light from the transparent material into the air, refraction due to the quality of the transparent material occurs. Thus, a position of the display 11 is determined in view of a refraction angle (the same applies to the following embodiments as well). The position of the display 11 with respect to the optical image formation means 13 can be determined freely to a certain extent, and focusing in the case of using a lens system is not necessary.

The optical image formation means 13 has, as illustrated in detail in FIG. 2, a tabular first light control panel 14 having a thickness t1 (e.g., 0.1 to 5 mm) and a tabular second light control panel 15 having a thickness t2 (e.g., 0.1 to 5 mm) arranged in a way that brings one side of both the first and second light control panels 14 and 15 in direct contact with or proximity to each other. A number of belt-like planar light-reflective portions 18 and a number of belt-like planar light-reflective portions 19 are formed respectively side by side inside the first light control panel 14 at a constant pitch (p1) and perpendicularly to a surface on one side of the first light control panel 14 and side by side inside the second light control panel 15 at a constant pitch (p2) and perpendicularly to a surface on one side of the second light control panel 15. Here, the planar light-reflective portions 18 of the first light control panel 14 and the planar light-reflective portions 19 of the second light control panel 15 are arranged crossed (in this embodiment, in an orthogonal state) in planar view.

Parts of the first and second light control panels 14 and 15 where the planar light-reflective portions 18 and 19 do not exist are formed of a transparent material such as glass and transparent plastic. It is preferable for these planar light-reflective portions 18 and 19 each to be formed of a metal sheet having high reflection efficiency, a vapor-deposited metal, a metal sheet having a layer for an adhesive agent at an intermediate portion, or a mirror sheet, and it is preferable for both front and back sides of these planar light-reflective portions 18 and 19 each to be a reflective surface. However, the present invention also applies to a case where only one side is a reflective surface. A method for producing the optical image formation means 13 is described in, for example, WO 2009/131128 A1, etc. Among metals having high reflection efficiency are aluminum, silver, titanium, nickel, chromium and the like.

Normally, in view of production efficiency, it is preferable for each pitch p1 between the planar light-reflective portions 18 and each pitch p2 between the planar light-reflective portions 19 to be the same, and it is preferable for the thickness t1 of the first light control panel 14 and the thickness t2 of the second like control panel 15 to be the same. Thus, the pitches between both of the planar light-reflective portions 18 and 19 will hereinafter be represented by p, and the thickness of both the first and second light control panels 14 and 15 will hereinafter be represented by t. When planarly viewing such the optical image formation means 13, as illustrated in a partially enlarged view in FIG. 1, the planar light-reflective portions 18 and the planar light-reflective portions 19 are crossed to form a number of square frames. An aspect ratio γ (height/width) of a single frame (i.e., a frame of one layer) in this case is thickness (t)/pitch (p). The aspect ratio γ is approximately 1 to 4.5, however, in order to obtain an even brighter real image 12 by making light reflect off one of the planar light-reflective portions 18 and one of the planar light reflective portions 19 a plurality of times, it is desirable for the aspect ratio γ to be 2.5 to 4.5 (in more detail, aspect ratio γ that exceeds 3 and is 4.5 or less).

Every single frame part of the first and second light control panels 14 and 15 forms each of first minute reflective surfaces 20 and second minute reflective surfaces 21 crossed in planar view. These first minute reflective surfaces 20 are arranged in a state of standing numerously on a same plane, and these second minute reflective surfaces 21 are arranged in a state of standing numerously on a same plane. Therefore, light from the display 11 arranged on one side of the optical image formation means 13 reflects off each of the first minute reflective surfaces 20 of the first light control panel 14 (first reflected light) on the front side (the side of the display 11), subsequently reflects off each of the corresponding second minute reflective surfaces 21 (second reflected light), and forms a real image 12 on the other side of the optical image formation means 13. This real image 12 becomes formed in space, and becomes the same in size as an image 11a formed on the display 11. Aside from cases where light reflects only on the inside of one frame, cases where light jumps over one frame and reflects are also included as incident light and reflected light.

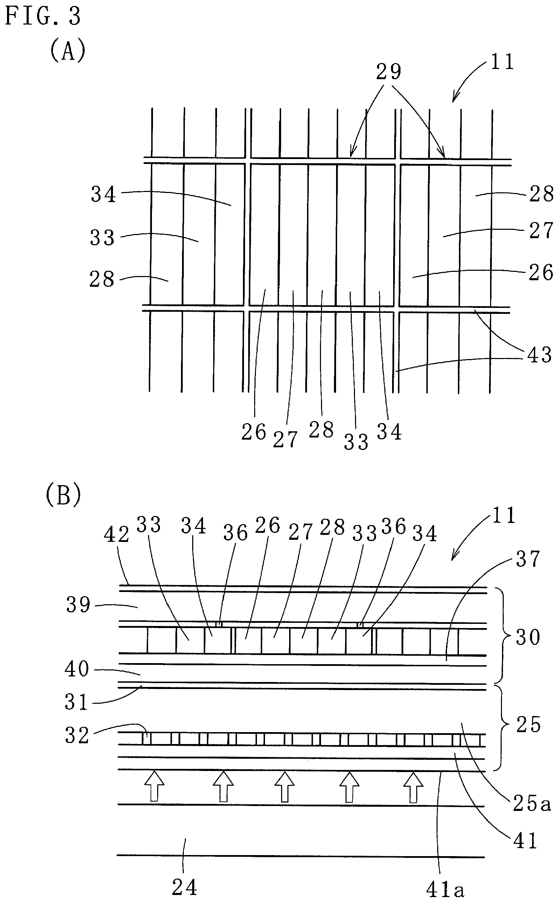

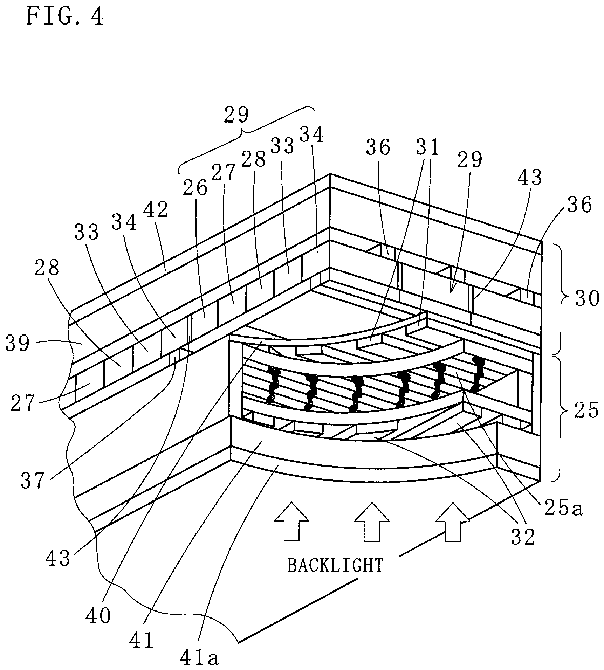

Next, with reference to FIGs. 3(A), 3(B) and 4, descriptions will be given on the display 11 having been used for the apparatus for contactless input 10. This display 11 is basically a liquid-crystal type, and is provided with a backlight 24, a liquid-crystal portion 25, and a display portion 30 in which a number of cells (light-emitting blocks) 29 each having an R light-emitting means 26, a G light-emitting means 27 and a B light-emitting means 28 (hereinafter also simply referred to as the RGB light-emitting means 26 to 28), which are an example of visible-light emitting portions, are arranged in a lattice pattern. Here, the R light-emitting means 26, the G light-emitting means 27, and the B light-emitting means 28 do not emit light by themselves, refer to a portion that emits R (red) light, a portion that emits G (green) light, and a portion that emits B (blue) light, respectively, when light from the backlight 24 passes through the liquid-crystal portion 25, and can be replaced by simple color filters.

The liquid-crystal portion 25 has a well-known structure, which receives electric power by means of belt-like transparent electrodes 31 and belt-like transparent electrodes 32 arranged one above the other along X and Y directions respectively in a lattice pattern, and can be controlled between a light-shielding state and a light-transmitting state in increments of a cell (i.e., in increments of each RGB light-emitting means 26 to 28). Each of the cells 29 arranged in the display portion 30 has one of infrared-light emitting portions 33 and one of infrared sensors 34 that are examples of light sensors, aside from one of the RGB light-emitting means 26 to 28. Belt-like transparent electrodes 36 and belt-like transparent electrodes 37, both of which obtaining light signals from (in some cases, feeding power to) the infrared sensors 34, are respectively arranged above the infrared sensors 34 and below the infrared sensors 34 one above the other in a lattice pattern. In FIGs. 3(A) and 3(B), numerals 39 to 41 and 41a each represent a transparent protection plate material, a numeral 42 represents a deflection filter, and a numeral 43 represents barriers of each of the cells 29. As a light source for the backlight 24, a light source including red, blue and green visible lights and also including infrared light is used. The liquid-crystal portion 25 is controlled using the transparent electrodes 31 and 32, and the infrared sensors 34 are controlled using the transparent electrodes 36 and 37. Here, a numeral 25a represents a body of the liquid-crystal portion. The directions of the transparent electrodes 31 and 32, and 36 and 37 illustrated in FIG. 4 are illustrated differently from the directions of those illustrated in FIG. 3. Therefore, the display 11 illustrated in FIG. 4 is a variation of the display 11 illustrated in FIG. 3. Light sensors can be provided to all light-emitting blocks or can be provided to selected light-emitting blocks.

Descriptions will be given on behaviors of this display 11. When the liquid-crystal portion 25 corresponding to (i.e., to be immediately beneath) the RBG light-emitting means 26 to 28 and the infrared-light emitting portions 33 in each of the cells 29 is turned on and off through the transparent electrodes 31 and 32 with the backlight 24 in the state of being lit, visible light and infrared light become generated from one of the cells 29. This enables the formation of an image 11a on the display 11, and at the same time, infrared light of even illuminance becomes generated from the display 11.

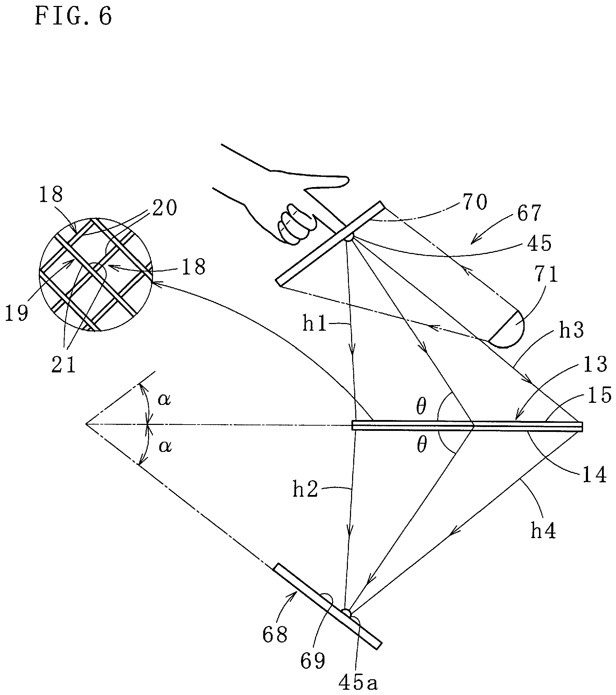

Light rays (r1 to r4) from the image 11a displayed on the display 11, as illustrated in FIG. 1, go into the optical image formation means 13, and a real image 12 (the first real image, the same applies hereinafter) becomes formed on the other side of the optical image formation means 13. The display 11 and the real image 12 become formed bilaterally or vertically symmetrical to each other centering on the optical image formation means 13. In this case, infrared light emitted from the infrared-light emitting portions 33 of the display 11 goes into a state of a sheet, and becomes formed superimposed on the position of the real image 12. However, the formed infrared light cannot be visually confirmed.
Here, as illustrated in FIG. 1, when a finger (substitutable with a touch pen, a pointer, etc.), an example of an indicating means 45, is inserted in a predetermined position on the real image 12, reflected light of infrared light becomes produced from the indicating means 45, and from an image of the reflected infrared light, a second real image 45a becomes formed on the side of the display 11 (i.e., on the display 11) through the optical image formation means 13. As illustrated in FIG. 1, the reflected light rays of the infrared light from the indicating means 45 enter into the optical image formation means 13 through return circuits of r1' and r3', become refracted by and reflect off the optical image formation means 13, pass through return circuits of r2' and r4' and form the second real image 45a. Since the second real image 45a is an image formation by means of infrared light rays, the second real image 45a cannot be visually confirmed. In FIG. 1 (the same applies to FIG. 6), θ indicates that the first real image 12 (70) and the second real image 45a become formed symmetrical to each other with respect to the optical image formation means 13. r1 to r4 and r1' to r4' represent infrared light rays outside a beam of infrared light rays contributing to the image formation.

Here, an infrared image of the indicating means 45 is detected by the infrared sensors 34 arranged in the display 11, thereby detecting a part on the real image 12 pressed by the indicating means 45. When the real image 12 is, for example, a keyboard and the like, a pressed position on the keyboard can be detected. Therefore, in the case of this apparatus for contactless input 10, external infrared-light emitting portions, an external infrared camera and the like are not necessary.

Next, descriptions will be given on an apparatus for contactless input 50 according to a second embodiment of the present invention. When components are the same as those of the apparatus for contactless input 10 according to the first embodiment, the same numerals will be assigned to these components, and detailed description on them will be omitted (the same applies to the following embodiments as well).
As illustrated in FIGs. 1 and 2, this apparatus for contactless input 50 is provided with an optical image formation means 13 that is formed at an angle α of 30 to 60 degrees to and at a distance from a planar display 51 and that forms a real image 12 at a position symmetric to an image 11a displayed on the display 51 by making light from the image 11a enter into the optical image formation means 13.

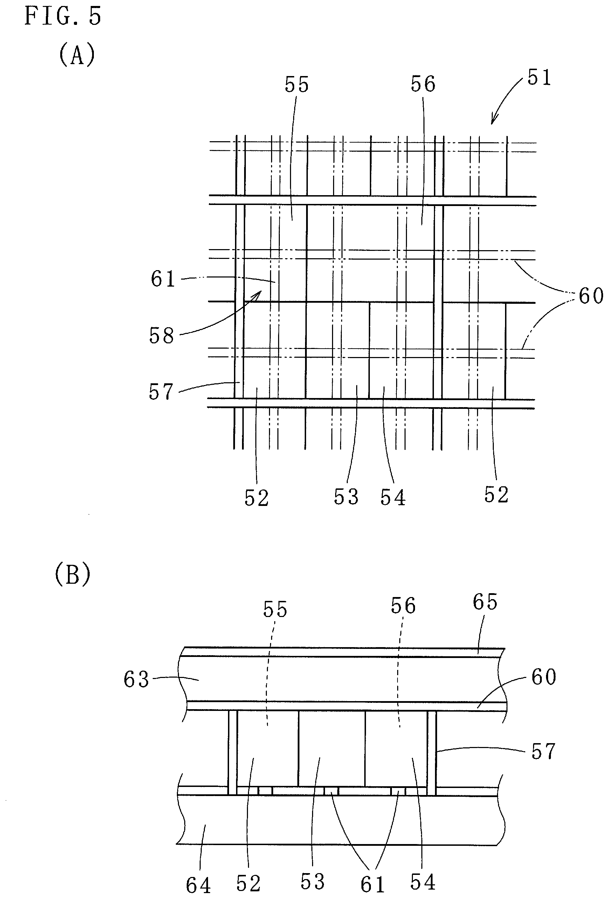

A partially enlarged view of the display 51 is illustrated in FIG. 5(A), and an enlarged cross-section of the display 51 is illustrated in FIG. 5(B). The display 51 of this apparatus for contactless input 50 is a light-emitting diode type, not a liquid-crystal type. Therefore, the display 51 is provided with a number of cells (light-emitting blocks) 58 each having one of infrared-light emitting portions 55 formed of light-emitting diodes and one of infrared sensors (an example of light sensors) 56 formed of photo diodes and the like, aside from one of R light-emitting means 52, one of G light-emitting means 53, and one of B light-emitting means 54 (visible-light emitting portions) each formed of a light-emitting diode. A numeral 57 represents barriers separating each of the cells 58, and numerals 60 and 61 represent belt-like transparent electrodes feeding power to each of the light-emitting diodes of the R light-emitting means 52, the G light-emitting means 53, and the B light-emitting means 54 and receiving signals from the infrared sensors 56. The transparent electrodes 61 can be non-transparent. A numeral 63 represents a transparent protection plate material, a numeral 64 represents a protection plate material, and a numeral 65 represents a deflection filter.

An image of visible light rays containing red, green, and blue light, and infrared light can thereby be emitted from the display 51, and a real image 12 is formed from an image 11a displayed on the display 51 in space at a symmetrical position to the image 11a through the optical image formation means 13.
When touching the real image 12 with an indicating means 45, an infrared image (a second real image 45a) is formed on the surface of the display 51 by infrared light reflected through the optical image formation means 13, and a position on the real image 12 where the indicating means 45 has touched can be detected by the infrared sensors 56.

An apparatus for contactless input 67 according to a third embodiment of the present invention illustrated in FIG. 6 is provided with an optical image formation means 13 that is formed at an angle α of 30 to 60 degrees to and at a distance from a planar display 68, and that makes light from an image (an image of a keyboard, an image of a touch panel, etc.) 69 displayed on the display 68 enter and forms a real image (a first real image) 70 of the image 69 at a symmetrical position to the image 69. Here, an infrared-light emitting means 71 that irradiates the whole of the real image 70 with infrared light is provided on the other side of the optical image formation means 13. This infrared-light emitting means 71 is formed of, for example, an infrared-light emitting diode, an infrared lamp and the like, and is structured to infallibly irradiate an indicating means 45 having come into contact with the real image 70 from the side of the optical image formation means 13, and to emit reflected light toward the optical image formation means 13. The infrared-light emitting means 71 does not irradiate light (infrared light) toward the optical image formation means 13 in principle.

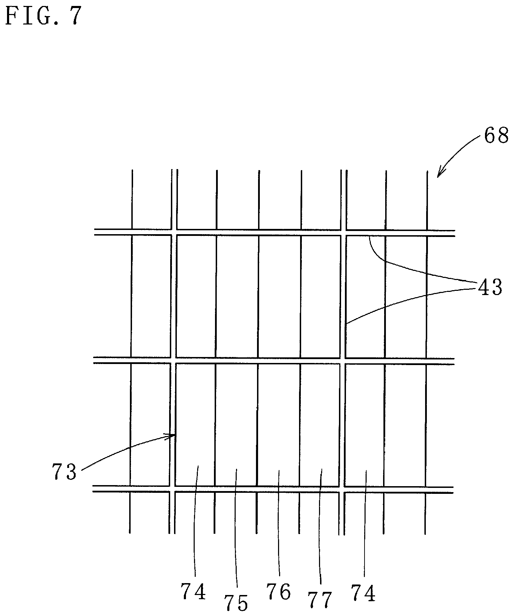

The display 68 has, as illustrated in FIG. 7, a number of light-emitting blocks (cells) 73, and each of the light-emitting blocks 73 is provided with one of visible-light emitting portions each having one of R light-emitting means 74, one of G light-emitting means 75 and one of B light-emitting means 76, and also provided with one of infrared sensors 77 which are an example of light sensors. When the display 68 is a liquid-crystal type, a liquid-crystal portion is provided on the bottom of the RGB light-emitting means 74 to 76, and when the display 68 is a light-emitting diode type, the RGB light-emitting means 74 to 76 each are formed of a light-emitting diode.

Therefore, in the case of the apparatus for contactless input 67 according to the third embodiment, by means of the infrared-light emitting means 71, the indicating means (a finger, a touch pen, etc.) 45 is irradiated with infrared light, and as illustrated in FIG. 6, reflected infrared light within the range of between h1 and h3 passes through the optical image formation means 13 and a second real image 45a becomes formed on the display 68. h2 and h4 represent infrared light rays passing the outside after passing through the optical image formation means 13. A position of the second real image 45a is detected by the infrared sensors 77. When an area of the second real image 45a is large, the position of the second real image 45a becomes detected by a number of the infrared sensors 77. Thus, it is preferred that image processing be performed to, for example, find a position of the center of gravity of the second real image 45a to make it an output of the display 68.

In the case of the apparatuses for contactless input 10, 50 and 67 according to the above first to third embodiments, in order to separate infrared signals via the infrared-light emitting portions 33 and 55 and via the infrared-light emitting means 71 from infrared light outside, it is preferred that the infrared signals be made to be on-off signals or waveform signals by means of modulation. In the case of the apparatus for contactless input 10, the modulation is performed by controlling the liquid crystals, in the case of the apparatus for contactless input 50, the modulation is performed by modulating the power to be fed to the infrared-light emitting portions (light-emitting diodes) 55, and in the case of the apparatus for contactless input 67, by modulating the power to be fed to the infrared-light emitting means 71.
The infrared sensors 34, 56 and 77 each select necessary signals through a filter after once changing received infrared light to electrical signals.

In the above embodiments, infrared light was used aside from visible light. However, it is also possible to structure an apparatus for contactless input without using infrared light and by using only visible light. In this case, the infrared-light emitting portions do not exist inside the cells, and the apparatus for contactless input is provided with visible light sensors instead of infrared sensors. Therefore, a light-sensitive touch panel for use in an ordinary personal computer can also be diverted to the apparatus for contactless input that uses only visible light. In this case, it is preferred that visible light be modulated, and the light sensors may be made to detect only part of light among the visible light. Infrared light also includes light rays having longer wavelengths than those of visible light rays, for example, far infrared rays and the like.

The present invention is not limited to the above embodiments, and applies to, for example, cases where the contactless input is performed by replacing parts of the structures of the apparatuses for contactless input according to the first to third embodiments with one another.
In the first to third embodiments, forms and structures of the light-emitting blocks (cells) were specifically described. However, improvement and changes of forms within the scope of the present claims are possible. Also, in the above embodiments, RGB light-emitting means are used. However, the order of the colors may be changed, and moreover, colors other than R, G, and B may be combined, and furthermore, the colors may be monochrome.

### INDUSTRIAL APPLICABILITY

The apparatuses and methods for contactless input (apparatuses and methods for contactlessly detecting an indicated position on a reproduced image) according to the present invention form in the air a reproduced image of a control panel having operation buttons (e.g., a keyboard and a touch panel) when used for control panels of various types of machinery, and are capable of obtaining input signals when the operation buttons on the reproduced image are pressed. Therefore, the apparatuses and methods for contactless input according to the present invention can be used not only for control panels of factory machines, but also optimally for touch panels of mobile phones, personal computers, automobiles, vessels and the like.

### REFERENCE SIGNS LIST

10: apparatus for contactless input, 11: display, 11a: image, 12: real image (first real image), 13: optical image formation means, 14: first light control panel, 15: second light control panel, 18, 19: planar light-reflective portion, 20: first minute reflective surface, 21: second minute reflective surface, 24: backlight, 25: liquid-crystal portion, 25a: body of a liquid-crystal portion, 26: R light-emitting means, 27: G light-emitting means, 28: B light-emitting means, 29: cell, 30: display portion, 31, 32: transparent electrode, 33: infrared-light emitting portion, 34: infrared sensor, 36, 37: transparent electrode, 39, 40, 41, 41a: protection plate material, 42: deflection filter, 43: barrier, 45: indicating means, 45a: second real image, 50: apparatus for contactless input, 51: display, 52: R light-emitting means, 53: G light-emitting means, 54: B light-emitting means, 55: infrared-light emitting portion, 56: infrared sensor, 57: barrier, 58: cell, 60, 61: transparent electrode, 63: transparent protection plate material, 64: protection plate material, 65: deflection filter, 67: apparatus for contactless input, 68: display, 69: image, 70: real image (first real image), 71: infrared-light emitting means, 73: light-emitting block, 74: R light-emitting means, 75: G light-emitting means, 76: B light-emitting means, 77: infrared sensor

## Claims

1. An apparatus for contactless input (10; 50; 67), comprising:
a display (11; 51; 68) having a number of light-emitting blocks (73), part or all of the light-emitting blocks (73) each having a light sensor incorporated; and
an optical image formation means (13) having a number of first minute reflective surfaces (20) and a number of second minute reflective surfaces (21) arranged crossed in planar view, the first minute reflective surfaces (20) arranged standing on a same plane, the second minute reflective surfaces (21) arranged standing on a same plane, first reflected light from each of the first minute reflective surfaces (20) being reflected on the corresponding second minute reflective surfaces (21) to form second reflected light,
wherein
a first real image (12; 70) is formed from an image (11a; 69) on the display (11; 51; 68) by means of the optical image formation means (13), the display (11; 51; 68) being arranged on one side of the optical image formation means (13), the first real image (12; 70) being formed on the other side of the optical image formation means (13);
a second real image (45a) is formed on the display (11; 51; 68) on one side of the optical image formation means (13), from an image of an indicating means (45) having come into contact with the first real image (12; 70); and
a position of the second real image (45a) is detected by the light sensors of the display (11; 51; 68),

2. The apparatus for contactless input (10; 50; 67) according to claim 1, wherein
the light sensors are infrared sensors (34; 56; 77), and each of the light-emitting blocks (73) has one of infrared-light emitting portions (33; 55) and one of the infrared sensors (34; 56; 77) aside from one of visible-light emitting portions.

3. The apparatus for contactless input (10; 50; 67) according to claim 1, wherein
the light sensors are infrared sensors (34; 56; 77), each of the light-emitting blocks (73) has one of the infrared sensors (34; 56; 77) besides the visible-light emitting portions, an infrared-light emitting means (71) irradiating the indicating means (45) having come into contact with the first real image (12; 70) from the side of the optical image formation means (13) is provided separately from the display (11; 51; 68), and the position of the second real image (45a) is detected by the infrared sensors (34; 56; 77).

4. The apparatus for contactless input (10; 50; 67) according to claim 2 or 3, wherein
each of the visible-light emitting portions has an R light-emitting means (26; 52; 74), a G light-emitting means (27; 53; 75) and a B light-emitting means (28; 54; 76).

5. The apparatus for contactless input (10; 50; 67) according to any one of claims 1 to 4, wherein
the display (11; 51; 68) is a liquid-crystal type.

6. The apparatus for contactless input (10; 50; 67) according to any one of claims 1 to 4, wherein
the display (11; 51; 68) is a light-emitting diode type.

7. A method for contactless input (10; 50; 67), using a display (11; 51; 68) having a number of light-emitting blocks (73), part or all of the light-emitting blocks (73) each having a light sensor incorporated, and an optical image formation means (13) having first minute reflective surfaces (20) and second minute reflective surfaces (21) arranged crossed in planar view, the first minute reflective surfaces (20) arranged in a state of standing numerously on a same plane, the second minute reflective surfaces (21) arranged in a state of standing numerously on a same plane, first reflected light from each of the first minute reflective surfaces (20) being reflected on each of the corresponding second minute reflective surfaces (21) to form second reflected light,
the method for contactless input (10; 50; 67), comprising steps of:
forming a first real image (12; 70) from an image on the display (11; 51; 68) arranged on one side of the optical image formation means (13) by means of the optical image formation means (13), the first real image (12; 70) being formed on the other side of the optical image formation means (13);
forming a second real image (45a) from an image of an indicating means (45) having come into contact with the first real image (12; 70), the second real image (45a) being formed on the display (11; 51; 68) on one side of the optical image formation means (13); and
detecting a position of the second real image (45a) formed on the display (11; 51; 68) on one side of the optical image formation means (13) by means of the light sensors of the display (11; 51; 68).

8. The method for contactless input (10; 50; 67) according to claim 7, wherein
the light sensors are infrared sensors (34; 56; 77), and each of the light-emitting blocks (73) is provided with one of the infrared sensors (34; 56; 77) aside from one of visible-light emitting portions each having an R light-emitting means (26; 52; 74), a G light-emitting means (27; 53; 75) and a B light-emitting means (28; 54; 76).

9. The method for contactless input (10; 50; 67) according to claim 8, wherein
each of the light-emitting blocks (73) is provided with one of infrared-light emitting portions (33; 55).

10. The method for contactless input (10; 50; 67) according to claim 7 or 8, wherein
an infrared-light emitting means (71) irradiating infrared light toward the indicating means (45) is provided.

## Patentansprüche

1. Vorrichtung für kontaktlose Eingabe (10; 50; 67), aufweisend:
einen Bildschirm (11; 51; 68) mit einer Anzahl von lichtemittierenden Blöcken (73), wobei ein Teil der oder alle lichtemittierenden Blöcke (73) jeweils einen Lichtsensor eingebaut haben; und
eine optische Bilderzeugungseinrichtung (13) mit einer Anzahl von ersten winzigen reflektierenden Oberflächen (20) und einer Anzahl von zweiten winzigen reflektierenden Oberflächen (21), die in Aufsicht kreuzweise angeordnet sind, wobei sich die ersten winzigen reflektierenden Oberflächen (20) auf einer gleichen Ebene angeordnet befinden, sich die zweiten winzigen reflektierenden Oberflächen (21) auf einer gleichen Ebene angeordnet befinden, erstes reflektiertes Licht von jeder der ersten winzigen reflektierenden Oberflächen (20) an den entsprechenden zweiten winzigen reflektierenden Oberflächen (21) reflektiert wird, um zweites reflektiertes Licht zu bilden,
wobei:
ausgehend von einem Bild (11a; 69) auf dem Bildschirm (11; 51; 68) ein erstes reales Bild (12; 70) mit Hilfe der optischen Bilderzeugungseinrichtung (13) erzeugt wird, wobei der Bildschirm (11; 51; 68) auf der einen Seite der optischen Bilderzeugungseinrichtung (13) angeordnet ist und das erste reale Bild (12; 70) auf der anderen Seite der optischen Bilderzeugungseinrichtung (13) erzeugt wird;
ausgehend von einem Bild einer Anzeigeeinrichtung (45), die in Kontakt mit dem ersten realen Bild (12; 70) gekommen ist, ein zweites reales Bild (45a) auf dem Bildschirm (11; 51; 68) auf einer Seite der optischen Bilderzeugungseinrichtung (13) erzeugt wird; und
eine Position des zweiten realen Bilds (45a) mit Hilfe der Lichtsensoren des Bildschirms (11; 51; 68) detektiert wird.

2. Vorrichtung für kontaktlose Eingabe (10; 50; 67) nach Anspruch 1, wobei
die Lichtsensoren Infrarot-Sensoren (34; 56; 77) sind und jeder der lichtemittierenden Blöcke (73) einen von infrarotlichtemittierenden Abschnitten (33; 55) und einen der Infrarot-Sensoren (34; 56; 77) hat, zusätzlich zu einem von sichtbares Licht emittierenden Abschnitten.

3. Vorrichtung für kontaktlose Eingabe (10; 50; 67) nach Anspruch 1, wobei
die Lichtsensoren Infrarot-Sensoren (34; 56; 77) sind,
jeder der lichtemittierenden Blöcke (73) einen der Infrarot-Sensoren (34; 56; 77) hat, zusätzlich zu den sichtbares Licht emittierenden Abschnitten,
eine infrarotlichtemittierende Einrichtung (71), die die Anzeigeeinrichtung (45), die in Kontakt mit dem ersten realen Bild (12; 70) gekommen ist, von der Seite der optischen Bilderzeugungseinrichtung (13) aus bestrahlt, separat zu dem Bildschirm (11; 51; 68) bereitgestellt ist, und
die Position des zweiten realen Bilds (45a) von den Infrarotsensoren (34; 56; 77) detektiert wird.

4. Vorrichtung für kontaktlose Eingabe (10; 50; 67) nach Anspruch 2 oder 3, wobei
jeder der sichtbares Licht emittierenden Abschnitte eine R-Licht emittierende Einrichtung (26; 52; 74), eine G-Licht emittierende Einrichtung (27; 53; 75) und eine B-Licht emittierende Einrichtung (28; 54; 76) hat.

5. Vorrichtung für kontaktlose Eingabe (10; 50; 67) nach einem der Ansprüche 1 bis 4, wobei der Bildschirm (11; 51; 68) vom Typ Flüssigkristall ist.

6. Vorrichtung für kontaktlose Eingabe (10; 50; 67) nach einem der Ansprüche 1 bis 4, wobei der Bildschirm (11; 51; 68) vom Typ lichtemittierende Diode ist.

7. Verfahren für kontaktlose Eingabe (10; 50; 67) unter Verwendung
eines Bildschirms (11; 51; 68) mit einer Anzahl von lichtemittierenden Blöcken (73), wobei ein Teil der oder alle lichtemittierenden Blöcke (73) jeweils einen Lichtsensor eingebaut haben, und
einer optischen Bilderzeugungseinrichtung (13) mit ersten winzigen reflektierenden Oberflächen (20) und zweiten winzigen reflektierenden Oberflächen (21), die in Aufsicht kreuzweise angeordnet sind, wobei die ersten winzigen reflektierenden Oberflächen (20) in einem zahlreich auf einer gleichen Ebene befindlichen Zustand angeordnet sind, die zweiten winzigen reflektierenden Oberflächen (21) in einem zahlreich auf einer gleichen Ebene befindlichen Zustand angeordnet sind, erstes reflektiertes Licht von jeder der ersten winzigen reflektierenden Oberflächen (20) an jeder der entsprechenden zweiten winzigen reflektierenden Oberflächen (21) reflektiert wird, um zweites reflektiertes Licht zu bilden,
wobei das Verfahren für kontaktlose Eingabe (10; 50; 67) die folgenden Schritte aufweist:
Erzeugen eines ersten realen Bilds (12; 70) ausgehend von einem Bild auf dem Bildschirm (11; 51; 68), der auf der einen Seite der optischen Bilderzeugungseinrichtung (13) angeordnet ist, mit Hilfe der optischen Bilderzeugungseinrichtung (13), wobei das erste reale Bild (12; 70) auf der anderen Seite der optischen Bilderzeugungseinrichtung (13) erzeugt wird;
Erzeugen eines zweiten realen Bilds (45a) ausgehend von einem Bild einer Anzeigeeinrichtung (45), die in Kontakt mit dem ersten realen Bild (12; 70) gekommen ist, wobei das zweite reale Bild (45a) auf dem Bildschirm (11; 51; 68), der auf der einen Seite der optischen Bilderzeugungseinrichtung (13) angeordnet ist, erzeugt wird; und
Detektieren einer Position des zweiten realen Bilds (45a), das auf dem auf der einen Seite der optischen Bilderzeugungseinrichtung (13) angeordneten Bildschirm (11; 51; 68) erzeugt worden ist, mit Hilfe der Lichtsensoren des Bildschirms (11; 51; 68).

8. Verfahren für kontaktlose Eingabe (10; 50; 67) nach Anspruch 7, wobei die Lichtsensoren Infrarot-Sensoren (34; 56; 77) sind und jeder der lichtemittierenden Blöcke (73) mit einem der Infrarot-Sensoren (34; 56; 77) versehen ist, zusätzlich zu einem von sichtbares Licht emittierenden Abschnitten, die jeweils eine R-Licht emittierende Einrichtung (26; 52; 74), eine G-Licht emittierende Einrichtung (27; 53; 75) und eine B-Licht emittierende Einrichtung (28; 54; 76) haben.

9. Verfahren für kontaktlose Eingabe (10; 50; 67) nach Anspruch 8, wobei jeder der lichtemittierenden Blöcke (73) mit einem von infrarotlichtemittierenden Abschnitten (33; 55) versehen ist.

10. Verfahren für kontaktlose Eingabe (10; 50; 67) nach Anspruch 7 oder 8, wobei eine infrarotlichtemittierende Einrichtung (71), die Infrarotlicht hin zur Anzeigeeinrichtung (45) strahlt, bereitgestellt ist.

## Revendications

1. Appareil d'entrée sans contact (10 ; 50 ; Z1286 EP/DE/NI S5 67), comprenant
un écran d'affichage (11 ; 51 ; 68) présentant un nombre de blocs électroluminescents (73), dans lequel chaque bloc d'une partie ou de la totalité des blocs électroluminescents (73) présente un capteur de lumière incorporé ; et
un moyen de formation d'image optique (13) présentant un nombre de premières surfaces réfléchissantes minuscules (20) et un nombre de secondes surfaces réfléchissantes minuscules (21) agencées de manière croisée en vue planaire, les premières surfaces réfléchissantes minuscules (20) étant agencées sur un même plan, les secondes surfaces réfléchissantes minuscules (21) étant agencées sur un même plan, une première lumière réfléchie provenant de chacune des premières surfaces réfléchissantes minuscules (20) étant réfléchie sur les secondes surfaces réfléchissantes minuscules correspondantes (21), en vue de former une seconde lumière réfléchie, dans lequel
une première image réelle (12 ; 70) est formée à partir d'une image (11a ; 69) sur l'écran d'affichage (11 ; 51 ; 68) au moyen du moyen de formation d'image optique (13), l'écran d'affichage (11 ; 51 ; 68) étant agencé sur un côté du moyen de formation d'image optique (13), la première image réelle (12 ; 70) étant formée sur l'autre côté du moyen de formation d'image optique (13) ;
une seconde image réelle (45a) est formée sur l'écran d'affichage (11 ; 51 ; 68) sur un côté du moyen de formation d'image optique (13), à partir d'une image d'un moyen d'indication (45) qui est entré en contact avec la première image réelle
(12 ; 70) ; et
une position de la seconde image réelle (45a) est détectée par les capteurs de lumière de l'écran d'affichage (11 ; 51 ; 68).

2. Appareil d'entrée sans contact (10 ; 50 ; 67) selon la revendication 1, dans lequel :
les capteurs de lumière sont des capteurs infrarouges (34 ; 56 ; 77), et chacun des blocs électroluminescents (73) présente l'une parmi des parties d'émission de lumière infrarouge (33 ; 55) et l'un parmi des capteurs infrarouges (34 ; 56 ; 77) outre l'une parmi des parties d'émission de lumière visible.

3. Appareil d'entrée sans contact (10 ; 50 ; 67) selon la revendication 1, dans lequel :
les capteurs de lumière sont des capteurs infrarouges (34 ; 56 ; 77), dans lequel chacun des blocs électroluminescents (73) présente l'un des capteurs infrarouges (34 ; 56 ; 77), outre les parties d'émission de lumière visible, dans lequel un moyen d'émission de lumière infrarouge (71) irradiant le moyen d'indication (45) qui est entré en contact avec la première image réelle (12 ; 70) depuis le côté du moyen de formation d'image optique (13) est fourni séparément de l'écran d'affichage (11 ; 51 ; 68), et la position de la seconde image réelle (45a) est détectée par les capteurs infrarouges (34 ; 56 ; 77).

4. Appareil d'entrée sans contact (10 ; 50 ; 67) selon la revendication 2 ou 3, dans lequel :
chacune des parties d'émission de lumière visible présente un moyen d'émission de lumière rouge, R, (26 ; 52 ; 74), un moyen d'émission de lumière verte, G, (27 ; 53 ; 75) et un moyen d'émission de lumière bleue, B, (28 ; 54 ; 76).

5. Appareil d'entrée sans contact (10 ; 50 ; 67) selon l'une quelconque des revendications 1 à 4, dans lequel :
l'écran d'affichage (11 ; 51 ; 68) est du type à cristaux liquides.

6. Appareil d'entrée sans contact (10 ; 50 ; 67) selon l'une quelconque des revendications 1 à 4, dans lequel :
l'écran d'affichage (11 ; 51 ; 68) est du type à diode électroluminescente.

7. Procédé d'entrée sans contact (10 ; 50 ; 67), utilisant un écran d'affichage (11 ; 51 ; 68) présentant un nombre de blocs électroluminescents (73), dans lequel chaque bloc d'une partie ou de la totalité des blocs électroluminescents (73) présente un capteur de lumière incorporé, et un moyen de formation d'image optique (13) présentant des premières surfaces réfléchissantes minuscules (20) et des secondes surfaces réfléchissantes minuscules (21) agencées de manière croisée en vue planaire, les premières surfaces réfléchissantes minuscules (20) étant agencées en grande quantité sur un même plan, les secondes surfaces réfléchissantes minuscules (21) étant agencées en grande quantité sur un même plan, une première lumière réfléchie provenant de chacune des premières surfaces réfléchissantes minuscules (20) étant réfléchie sur chacune des secondes surfaces réfléchissantes minuscules correspondantes (21), en vue de former une seconde lumière réfléchie ;
le procédé d'entrée sans contact (10 ; 50 ; 67) comprenant les étapes ci-dessous consistant à :
former une première image réelle (12 ; 70) à partir d'une image sur l'écran d'affichage (11 ; 51 ; 68) agencé sur un côté du moyen de formation d'image optique (13), au moyen du moyen de formation d'image optique (13), la première image réelle (12 ; 70) étant formée sur l'autre côté du moyen de formation d'image optique (13) ;
former une seconde image réelle (45a) à partir d'une image d'un moyen d'indication (45) qui est entré en contact avec la première image réelle (12 ; 70), la seconde image réelle (45a) étant formée sur l'écran d'affichage (11 ; 51 ; 68), sur ledit un côté du moyen de formation d'image optique (13) ; et
détecter une position de la seconde image réelle (45a) formée sur l'écran d'affichage (11 ; 51 ; 68), sur ledit un côté du moyen de formation d'image optique (13), au moyen des capteurs de lumière de l'écran d'affichage (11 ; 51 ; 68).

8. Procédé d'entrée sans contact (10 ; 50 ; 67) selon la revendication 7, dans lequel :
les capteurs de lumière sont des capteurs infrarouges (34 ; 56 ; 77), et chacun des blocs électroluminescents (73) est muni de l'un des capteurs infrarouges (34 ; 56 ; 77), outre l'une parmi des parties d'émission de lumière visible présentant chacune un moyen d'émission de lumière rouge, R, (26 ; 52 ; 74), un moyen d'émission de lumière verte, G, (27 ; 53 ; 75) et un moyen d'émission de lumière bleue, B, (28 ; 54 ; 76).

9. Procédé d'entrée sans contact (10 ; 50 ; 67) selon la revendication 8, dans lequel :
chacun des blocs électroluminescents (73) est muni de l'une parmi des parties d'émission de lumière infrarouge (33 ; 55).

10. Procédé d'entrée sans contact (10 ; 50 ; 67) selon la revendication 7 ou 8, dans lequel :
un moyen d'émission de lumière infrarouge (71) irradiant une lumière infrarouge vers le moyen d'indication (45) est fourni.
